# EUROPÄISCHE PATENTANMELDUNG

(11) **EP 2 578 390 A1**
(43) Veröffentlichungstag der Anmeldung: **10.04.2013**
(21) Anmeldenummer: 11184318.1
(22) Anmeldetag: 07.10.2011
(51) Int. Cl.: B32B 15/08, C08L 69/00, C23C 14/02, C23C 14/20

(54) **Prozess zur Herstellung metallisierter Mehrschichtkörper aus speziellen Polycarbonaten**

(71) Anmelder: Bayer MaterialScience AG, 51373 Leverkusen (DE)
(72) Erfinder: Oser, Rafael Dr., 51368 Leverkusen (DE); Meyer, Alexander Dr., 51368 Leverkusen (DE)
(74) Vertreter: BIP Patents

(57) **Zusammenfassung**

Die Erfindung betrifft ein Verfahren zur Herstellung von mehrschichtigen Körpern, welche mindestens eine Metallschicht tragen. Desweiteren betrifft die Erfindung mehrschichtige Erzeugnisse umfassend mindestens drei Schichten enthaltend eine Substratschicht aus einem Substrat enthaltend spezielle Copolycarbonate, eine Metallschicht und mindestens eine weitere Schicht.

## Beschreibung

Die Erfindung betrifft ein Verfahren zur Herstellung von mehrschichtigen Körpern, welche mindestens eine Metallschicht tragen. Desweiteren betrifft die Erfindung mehrschichtige Erzeugnisse umfassend mindestens drei Schichten enthaltend eine Substratschicht aus einem Substrat enthaltend spezielle Copolycarbonate, eine Metallschicht und mindestens eine weitere Schicht.

Polycarbonate werden aufgrund ihrer hohen Wärmeformbeständigkeit u. a. in Bereichen eingesetzt, in denen mit einer erhöhten Temperaturbelastung zu rechnen ist. Mit speziellen Copolycarbonaten (wie z.B. bei einem Copolycarbonat basierend auf Bisphenol A und Bisphenol TMC (1,1-Bis-(4-hydroxyphenyl)-3,3,5-trimethylcyclohexan)) gelingt es, die Wärmeformbeständigkeit weiter zu erhöhen. Diese Polycarbonate eignen sich daher auch zur Herstellung von Linsen, Reflektoren, Lampenabdeckungen und -gehäusen etc., die einer höheren Temperaturbelastung ausgesetzt sind. Bei diesen Anwendungen sind praktisch immer erhöhte thermischen Eigenschaften wie hohe Vicat-Erweichungstemperatur (Wärmeformbeständigkeit) beziehungsweise hohe Glastemperatur in Kombination mit ausreichenden mechanischen Eigenschaften zwingend gefordert.

Polycarbonate aus Bisphenol A und Bisphenol TMC sind unter dem Handelsnamen Apec® von Bayer Materialscience AG kommerziell erhältlich.

Der Auftrag von Metallen auf das Polymer kann über verschiedene Methoden wie z.B. durch Aufdampfen oder Sputtern geschehen. Die Verfahren sind näher beschrieben z.B. in "Vakuumbeschichtung Bd. 1 bis 5", H. Frey, VDI-Verlag Düsseldorf 1995 oder "Oberflächen- und Dünnschicht-Technologie" Teil 1, R.A. Haefer, Springer Verlag 1987.

Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized plastics 5 & 6: Fundamental and applied aspects und H. Grünwald et al. in Surface and Coatings Technologiy 111 (1999) 287-296 beschrieben.

Weitere Schichten wie korrosionsmindernde Schutzschlichten kann in einem PECVD (plasma enhanced chemical vapour deposition) oder Plasmapolymerisationsprozess aufgebracht werden. Hierbei werden niedrigsiedende Precursoren haupsächlich auf Siloxan-Basis in ein Plasma verdampft und dadurch aktiviert, so dass sie einen Film bilden können. Typische Substanzen hierbei sind Hexamethyldisiloxan (HMDSO), Tetrametyldisiloxan, Decamethylcyclopentasiloxan, Octamethylcyclotetrasiloxan und Trimethoximethylsilan.

Copolycarbonate basierend auf Cycloalkylidendiphenolen sind bekannt und verschiedenen Publikationen beschrieben worden.

So beschreiben DE 3 903 103 A1, EP 414 083 A2 und EP 359 953 A1 die Herstellung und Verwendung von Polycarbonaten auf Basis von Cycloalkylidendiphenolen.

Auch eine Reihe von Zusammensetzungen enthaltend Copolycarbonate mit Cycloalkylidendiphenolen und verschiedene weitere polymere Komponenten sind beschrieben worden.

So beschreibt die EP 362 646 A2 Blends aus Copolycarbonate mit Cycloalkylidendiphenolen und Kautschuken.

Die EP 401 629 A2 beschreibt hochtemperaturstabile Blends aus Copolycarbonaten enthaltend Cycloalkylidenbisphenolen und ABS-Polymere.

Keine dieser Anmeldungen beschreibt verbesserte optische Eigenschaften an metallisierten Formkörpern bei Temperaturen oberhalb 160°C. Keine Publikation beschreibt Verfahren zu Herstellung metallisierter Formkörper. Aus dem bisherigen Stand der Technik ist nicht ersichtlich, wie das oben beschriebene Problem zu lösen ist.

In US 7,128,959 B2 werden metallisierte Formkörper beschrieben. Als Substratmaterial können dabei Polycarbonate Polysulfone oder Polyetherimide beziehungsweise deren Mischungen eingesetzt werden. Um eine gute Metallisierung zu gewährleisten, muss auf das jeweilige Substrat vor der Metallisierung eine Basisschicht aufgetragen werden. Mit dem Auftrag einer Basisschicht lässt sich das hier beschriebene Problem nicht lösen. Bei der in der vorliegenden Erfindung beschriebenen Zusammensetzung ist der Auftrag einer Basisschicht nicht nötig.

Neben einer guten Verarbeitbarkeit und guten mechanischen Eigenschaften müssen diese Materialien auch weiteren Anforderungen wie einer guten Oberflächenqualität im resultierenden Spritzgussteil / Extrudat sowie einer guten Metallhaftung genügen.

Je nach eingesetzten Bisphenolen und geeigneter Einstellung des Molekulargewichts der Copolycarbonate lassen sich die Wärmeformbeständigkeit und die mechanischen Eigenschaften in einem weiten Bereich variieren. Jedoch besteht für bestimmte Anwendungen nach wie vor der Bedarf einer weiter verbesserten Metallhaftung. So ist gerade im Bereich von Reflektoren eine gute Metallhaftung unabdingbar.

Wie oben beschrieben müssen die entsprechenden metallisierten Teile eine hohe Temperaturbeständigkeit aufweisen. So dürfen weder die mechanischen Eigenschaften noch die optischen Eigenschaften wie z.B. die Qualität der Metalloberfläche abnehmen. Es zeigte sich jedoch, dass metallisierte Formkörper aus speziellen Copolycarbonaten, welche Vicat-Erweichungstemperaturen von mehr als 160°C, insbesondere mehr als 170°C, aufweisen und welche u.a. 1,1-Bis-(4-hydroxyphenyl)-cyclohexan-Derivate enthalten, für spezielle Anwendungen eine oftmals nicht ausreichende optische Qualität bei sehr hohen Temperaturen aufweisen. So neigen derartige Formkörper, die unter speziellen Bedingungen, insbesondere unter PlasmaBedingungen, metallisiert und vorbehandelt wurden, unter speziellen Bedingungen überraschenderweise zu Blasenbildung (Blasen- und Rissbildung der Beschichtung) bei hohen Temperaturen (insbesondere bei Temperaturen oder Temperaturspitzen von größer 170°C). Dies kann zum Ausfall des entsprechenden Formköpers in der jeweiligen Anwendung führen. Durch die Blasenbildung verliert die Metalloberfläche ihr einheitliches Aussehen - ferner wird die Reflexion von Licht negativ beeinflusst.

Dieses Phänomen tritt überraschenderweise insbesondere dann auf, wenn die oben genannten Copolycarbonate bestimmte Additive wie bestimmte Thermostabilisatoren oder bestimmte Pigmente wie Titandioxid enthalten. Thermostabilisatoren dienen normalerweise dazu, das Substratmaterial vor Wärmeeinflüssen zu schützen, jedoch wird durch bestimmte Thermostabilisatoren überraschenderweise ein gegenteiliger Effekt erreicht. Titandioxid wird jedoch dazu verwendet, um in resultierenden Formkörpern eine bestimmte Farbe einzustellen und ist daher ein wichtiger Bestandteil von eingefärbten Zusammensetzungen. Sollte Titandioxid eingesetzt werden, wird Titandioxid in einer Menge von 0,10 Gew.-% bis 2,50 Gew.-%, bevorzugt in einer Menge von 0,20 Gew.-% bis 1,50 Gew.-% und insbesondere bevorzugt in einer Menge 0,80 Gew.-% bis 1,40 Gew.-% jeweils bezogen auf das Gewicht des Copolycarbonats eingesetzt. Der Verzicht auf Titandioxid und/oder Thermostabilisatoren führt dazu, andere Pigmente und Verbindungen einzusetzen, die deutlich teurer sind und dadurch das Verfahren weniger ökonimisch machen, und / oder in der Alterung instabil sind. Neben Titandioxid können weitere Farbmittel oder Pigmente wie Ruß eingesetzt werden. Eine häufig gewünschte Farbe im Elektronikbereich ist z.B. Grau (wie das sogenannte "Elektrograu"). Normalerweise sind derartige Pigmente auf Titandioxidbasis inert, jedoch führt die Anwesenheit derartiger Pigmente überraschenderweise zu einer drastisch verschlechterten Oberflächenqualität nach Temperaturbelastung.

Das Phänomen tritt jedoch ebenfalls in Abwesenheit solcher Thermostabilisatoren oder Pigmente auf, so dass mit den bisher aus dem Stand der Technik bekannten Verfahren nicht sichergestellt wird, dass die Copolycarbonate auch bei erhöhter Temperatur defektfrei bleiben.

Es bestand daher die Aufgabe ein Verfahren zu entwickeln, um Polycarbonate beziehungsweise Polycarbonatzusammensetzungen mit Glasstemperaturen von größer 160°C, bevorzugt größer 170°C, welche zumindest zu 60 % Copolycarbonate auf Basis von 1,1-Bis-(4-hydroxyphenyl)-cyclohexan-Derivaten enthalten, mit einer stabilen Metallschicht in einem DC-Sputterprozess zu versehen, bei dem sicher gestellt ist, dass defektfreie Metalloberflächen auch nach hoher Temperaturbelastung, d.h. bei Temperaturen oberhalb von 160°C, zuverlässig erhalten werden.

Ferner war die Aufgabe einen Mehrschichtkörper enthaltend ein Substratmaterial enthaltend zumindest zu 60 Gew.-% Copolycarbonate auf Basis von 1,1-Bis-(4-hydroxyphenyl)-cyclohexan-Derivaten sowie mindestens einer Metallschicht sowie einer weiteren Schicht zu entwickeln, welche eine hervorragende Oberflächenqualität aufweisen und die Oberflächenqualität auch unter hohen Temperaturen beibehalten.

Spezielle DC-Sputtermethoden und insbesondere Sputtermethoden in denen mit speziellen plasmagestützten Vorbehandlungsmethoden gearbeitet werden führen überraschenderweise dazu, dass die anschließende Metallschicht bei Wärmebehandlung Fehler ausbildet. Dies konnte nicht erwartet werden. Es muss betont werden, dass mit guter Metallisierbarkeit nicht nur die allgemeine Metallhaftung gemeint ist, sondern ebenfalls die Blisterbildung (Ausbildung blasenartiger Fehlstellen). Die Metallhaftung selbst kann auch mit niedrigen Vorbehandlungsenergien erreicht werden. Die Metallhaftung kann z.B. mit einem Peeltest (Klebebandabzugstest) getestet werden. Die Blisterbildung nach Wärmebehandlung kann jedoch nur durch das erfindungsgemäße Verfahren verhindert werden.

Mit Oberflächenstörungen nach Wärmebelastung sind vor allem Blasen, welche eine Zerstörung der metallischen Oberfläche zur Folge haben, gemeint. Darüber hinaus kann es zur Ausbildung einer eingetrübten Metalloberfläche nach Wärmebelastung kommen. Ferner kann als Fehler eine Irisierung der Oberfläche nach Wärmebelastung auftreten. Alle diese Fehler treten nur auf, wenn der metallisierte Körper einer Wärmebelastung unterzogen wird - es ist also vorher, d.h. direkt nach der Metallisierung, nicht zu erkennen, ob ein metallisierter Formkörper Oberflächenfehler ausbilden wird.

Weiterhin war überraschend, dass nicht jedes Metallisierungsverfahren zu einer Schädigung der Oberfläche unter Wärmebelastung führt. Wenn das entsprechende Metall nur aufgedampft und dabei das Substrat keinem Ionenbeschuß wie es in eine niederfrequenten Plasmavorbehandlung oder dem DC-sputtern der Fall ist ausgesetzt wird, ist der Polymer-Metallverbund sehr stabil und zeigt auch unter Wärmebelastung keine Ausbildung von Oberflächenstörungen. Die Oberflächenstörungen treten dann auf, wenn die Spritzgussteile im Plasma in einem DC-Sputterprozess beschichtet wurden. Aber auch hier führt nicht jedes Plasma-gestützte Verfahren zu einer anschließenden Oberflächenstörung. So muss noch ein weiterer niederfrequenter Plasmaschritt wie z.B. eine Plasmavorbehandlung geschehen. In diesem Verfahrenschritt wird mittels Plasma die Oberfläche von Verunreinigungen befreit und das Polymer für den anschließenden Metallauftrag gegebenenfalls aktiviert oder die Abscheidung des Top Coats. Dieser Schritt ist aufgrund des Reinigungs- und Aktivierungseffektes der Oberfläche in einem industriellen Prozess unerlässlich.

Weiterhin war es vollkommen überraschend, dass sich Substratmaterialien mit unterschiedlichen Gehalten an Bisphenolbausteinen der Formel (2) unterschiedlich verhalten. So müssen für verschiedene Substratmaterialien die jeweils optimalen Bedingungen eingestellt werden.

Überraschenderweise konnte die Aufgabe durch bestimmte Copolycarbonate, welche mit einem speziellen Verfahren behandelt und metallisiert wurden, gelöst werden. Nach diesem Verfahren erhaltene metallisierte mehrschichtige Formkörper erhalten eine defektfreie Metalloberfläche auch bei sehr hohen Gebrauchstemperaturen oberhalb von 160°C und insbesondere im Bereich von 160°C - 220°C. Die Aufgabe wurde durch ein bestimmtes Verfahren mit bestimmten Verfahrensparametern, um zu stabilen Metallschichten zu gelangen, gelöst. Die Kombination mit bestimmten Drücken und bestimmten Leistungen während der Vorbehandlung führt zu besseren Ergebnissen.

Der Standardmetallisierungsprozess umfasst drei Prozessschritte:
1. Plasmavorbehandlung
2. Metallisierung
3. Abscheidung einer Korrosionsschutzschicht

Die Metallschicht wird typischerweise aufgedampft oder DC-gesputtert (Kathodenzerstäubung über Gleichspannungsplasma). Für Schritt 1 und 3 werden typischerweise dieselben technischen Einrichtungen verwendet. Diese Schritte sind bereits hinreichend aus dem Stand der Technik bekannt.

Die Aufgabe wurde erfindungsgemäß durch ein Verfahren gelöst, welches wenigstens die folgenden Schritte umfasst:
a) Herstellung eines Formkörpers aus einem Copolycarbonat (nachfolgend auch als Komponente S bezeichnet) mit einer Vicat-Erweichungstemperatur nach DIN ISO 306 von größer als 160°C bevorzugt von größer als 165°C insbesondere bevorzugt größer als 170°C in einem herkömmlichen Extrusions- oder Spritzgussprozess, bevorzugt Spritzgussprozess, bei Temperaturen von 280°C bis 360°C, bevorzugt 300°C bis 350°C enthaltend als Endgruppe (Kettenabbrecher) eine Struktureinheit der Formel (1) 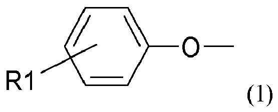 in der
   R1 für Wasserstoff oder C₁-C₁₈-Alkyl stehen; ganz besonders bevorzugt ist die Struktureinheit der Formel (1) ein Phenolat-Rest oder ein tert.-Butylphenolat-Rest oder ein n-Butylphenolat-Rest, insbesondere ein Phenolat-Rest oder ein p-tert. Butylphenolat-Rest,
   und mindestens ein Bisphenolbaustein der Formel (2) enthält, 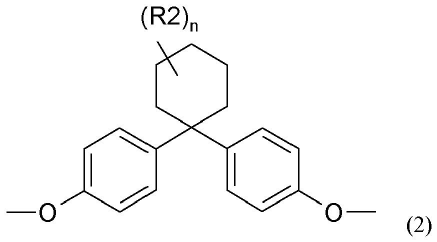 in der
   R2 für C₁-C₄-Alkyl, bevorzugt Methyl-, Ethyl-, Propyl-, Isopropyl- und Butyl- sowie Isobutylreste, besonders bevorzugt Methyl,
   n für 0, 1, 2 oder 3, bevorzugt 2 oder 3 stehen.

Bevorzugte Bisphenolbausteine der Formel (2) sind z.B. von 1,1-Bis-(4-hydroxyphenyl)-cyclohexan und 1,1-Bis-(4-hydroxyphenyl)-3,3,5-trimethylcyclohexan, bevorzugt 1,1-Bis-(4-hydroxyphenyl)-3,3,5-trimethylcyclohexan abgeleitet.

Dabei sind Copolycarbonate bevorzugt, die 15 Gew.-% bis 95 Gew.-% insbesondere bevorzugt 20 Gew.-% bis 88 Gew.-% und ganz besonders bevorzugt 25 Gew.-% bis 70 Gew.-%, bezogen auf das Gesamtgewicht der Bisphenolbausteine, Bisphenolbaustein der Formel (2) bezogen auf die Gesamtmenge an Bisphenolen enthalten, wobei die Summe sich auf 100% aufaddiert.

Ausser den Bisphenolen der Formel (2) sind für die Herstellung der Copolycarbonate geeignete Dihydroxyarylverbindungen solche der Formel (3)

HO-Z-OH (3)

in welcher
Z ein aromatischer Rest mit 6 bis 30 C-Atomen ist, der einen oder mehrere aromatische Kerne enthalten kann, substituiert sein kann und aliphatische oder cycloaliphatische Reste beziehungsweise Alkylaryle oder Heteroatome als Brückenglieder enthalten kann.

Bevorzugt steht Z in Formel (3) für einen Rest der Formel (3 a) 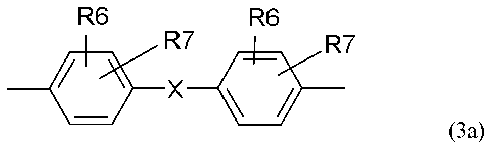 in der
R6 und R7 unabhängig voneinander für H, C₁-C₁₈-Alkyl-, C₁-C₁₈-Alkoxy, Halogen wie Cl oder Br oder für jeweils gegebenenfalls substituiertes Aryl- oder Aralkyl, bevorzugt für H oder C₁-C₁₂-Alkyl, besonders bevorzugt für H oder C₁-C₈-Alkyl und ganz besonders bevorzugt für H oder Methyl stehen, und
X für -SO₂-, -CO-, -O-, -S-, C₁- bis C₆-Alkylen, C₂- bis C₅-Alkyliden oder für C₆- bis C₁₂-Arylen, welches gegebenenfalls mit weiteren Heteroatome enthaltenden aromatischen Ringen kondensiert sein kann, steht.

Bevorzugt steht X für, C₁ bis C₅-Alkylen, C₂ bis C₅-Alkyliden, -O-, -SO-, -CO-, -S-, -SO₂-, Isopropyliden oder Sauerstoff, insbesondere für Isopropyliden.

Für die Herstellung der erfindungsgemäss zu verwendenden Copolycarbonate geeignete Bisphenole der Formel (3) sind beispielsweise Hydrochinon, Resorcin, Bis-(hydroxyphenyl)-alkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, [alpha],[alpha]'-Bis-(hydroxyphenyl)-diisopropylbenzole, sowie deren alkylierte, kernalkylierte und kernhalogenierte Verbindungen.

Ferner bevorzugte Bisphenole der Formel (3) sind 4,4'-Dihydroxydiphenyl, 2,2-Bis-(4-hydroxyphenyl)-1-phenyl-propan, 1,1-Bis-(4-hydroxyphenyl)-phenyl-ethan, 2,2-Bis-(4-hydroxyphenyl)-propan, 2,2-Bis-(3-methyl, 4-hydroxyphenyl)-propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)propan, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol.

Besonders bevorzugte Bisphenole der Formel (3) sind 2,2-Bis-(4-hydroxyphenyl)-propan (BPA), und 2,2-Bis-(3-methyl, 4-hydroxyphenyl)-propan.

Besonders bevorzugt sind Copolycarbonate aus Bisphenol A und Bisphenol TMC. Insbesondere bevorzugt sind damit Copolycarbonate die bevorzugt, 15 Gew.-% bis 95 Gew.-% insbesondere bevorzugt 20 Gew.-% bis 88 Gew.-% und ganz besonders bevorzugt 25 Gew.-% bis 70 Gew.-% , bezogen auf das Gesamtgewicht der Bisphenolbausteine, von Bisphenol TMC abgeleitete Blöcke enthalten (bezogen auf die Gesamtmenge an Bisphenolen) wobei der jeweils andere Gewichtsanteil von Bisphenol A gebildet wird und sich die Summe der Gewichtsanteile der beiden von Bisphenolabgeleiteten Blöcke jeweils auf 100 addiert.

Diese und weitere geeignete Bisphenole sind kommerziell erhältlich und z. B. in "H. Schnell, Chemistry and Physics of Polycarbonates, Interscience Publishers, New York 1964, S. 28 ff; S. 102 ff", und in "D. G. Legrand, J. T. Bendler, Handbook of Polycarbonate Science and Technology, Marcel Dekker New York 2000, S. 72 ff." beschrieben.

Die Komponente S kann dabei weitere Polymerbestandteile. Diese Polymerbestandteile sind bevorzugt Polymere der Strukturen (I) und/oder (II) und/oder (V)

-O-A-SO₂-A- (I)

-O-A-SO₂-A-O-B- (II)

worin A und B für gegebenenfalls substituierte aromatische Reste stehen können. Die aromatischen Reste bestehen aus 6 bis 40 C-Atomen, bevorzugt aus 6 - 21 C- Atomen, die einen oder mehrere gegebenenfalls kondensierte aromatische Kerne enthalten, wobei die Kerne gegebenenfalls Heteroatome enthalten können. Diese aromatischen Kerne können gegebenenfalls mit linearen oder verzweigten oder cycloaliphatischen C₁- bis C₁₅- Resten oder Halogenatomen substituiert sein. Die aromatischen Kerne können über Kohlenstoffbindungen oder über Heteroatome als Brückenglied verbunden sein.

A kann z.B. für Phenylen, Alkylphenylen, Alkoxyphenylen beziehungsweise für entsprechende Chlor- oder Fluor-substituierte Derivate stehen, bevorzugt für unsubstituierte Phenylenreste. B steht bevorzugt für von Bisphenolen abgeleitete Reste, denen die allgemeine Formel (III) oder (IV) zugrunde liegt 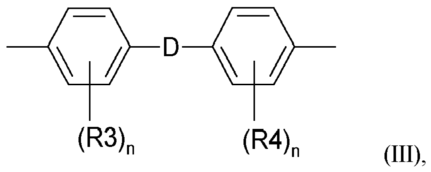 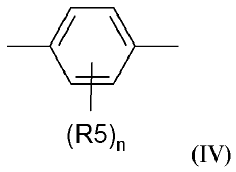 wobei R3, R4 und R5 jeweils unabhängig voneinander, gleich oder verschieden für Wasserstoff, Halogen, C₁-C₆-Alkyl, oder C₁-C₆-Alkoxy-, vorzugsweise für Wasserstoff, Fluor, Chlor, oder Brom steht,

n für eine ganze Zahl 1-4 vorzugsweise 1,2,3, insbesondere 1 oder 2 steht,

D für eine chemische Bindung -CO-, -O-, -S-, vorzugsweise für eine Einfachbindung steht.

### Polyetherimid der Formel (V)

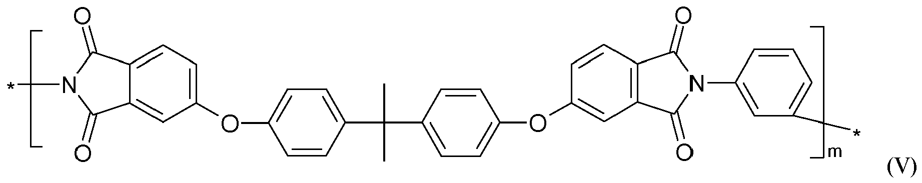

Bevorzugt sind dabei Polymere der Formel (I) wobei A für einen Phenylenrest steht. Diese sogenannten Polyethersulfone (CAS: 25608-63-3) sind z.B. unter dem Handelsnamen Ultrason® E 2010 bei der BASF SE (67056 Ludwigshafen, Deutschland) erhältlich.

Weiterhin bevorzugt sind Polymere der Formel (II) wobei A für einen Phenylenrest und B für einen Phenylenrest steht.

Insbesondere bevorzugt sind Polymere der Formel (II) wobei A für einen Phenylenrest und B für einen Biphenylenrest steht. Diese sogenannten Polyphenylsulfone (CAS 25608-64-4) sind unter dem Handelsnamen Radel® R (z.B. Radel® R 5900) bei Solvay Advanced Polymers oder Ultrason® P bei BASF SE (67056 Ludwigshafen, Deutschland) erhältlich.

Polyetherimide der Formel (V) sind z.B. unter Handelsnamen Ultem® (CAS 61128-46-9) (Sabic Innovative Plastics) bekannt.

Auch Mischungen der oben genannten Polymere sind möglich.

Die thermoplastischen Copolycarbonate haben Molekulargewichte Mw (Gewichtsmittel Mw, ermittelt durch Gelpermeationschromatographie GPC Messung) von 12 000 bis 120 000, vorzugsweise von 15 000 bis 80 000, insbesondere von 18 000 bis 60 000, ganz besonders bevorzugt von 18 000 bis 40 000 g/mol. Molekulargewichte lassen sich auch durch die Zahlenmittel Mn angeben, welche ebenfalls nach vorheriger Eichung auf Polycarbonat mittels GPC bestimmt werden.

Weiterhin kann die Komponente S weitere Additive enthalten, insbesondere niedermolekulare Additive.

Insbesondere bevorzugt ist die alleinige Verwendung von Copolycarbonate aus Bisphenol A und Bisphenol TMC.
b) Vorbehandlung des erhaltenen Formteils enthaltend ein Substratmaterial aus Komponente S mit einem Gewichtsanteil an 1,1-Bis-(4-hydroxyphenyl)-3,3,5-trimethylcyclohexan von 15 Gew.-% - 50 Gew.-% , bezogen auf das Gesamtgewicht der Bisphenolbausteine" in einer Diodenanordnung mit Mittelfrequenzanregung mit einem Luft- oder Argon-basierten Plasma, bevorzugt Argon, bei einer Frequenz von 0 Hz - 10 Mhz bevorzugt von 0 Hz - 1 Mhz ganz besonders bevorzugt 0 Hz - 100 kHz einer Leistung von 0,4 W/cm² bis 8,4 W/cm² bevorzugt 0.5 W/cm² bis 5,0 W/cm² insbesondere bevorzugt von 0,8 W/cm² bis 4,2 W/cm² sowie einem Prozessgasdruck von 0,04 bis 0,4 mbar bevorzugt von 0,05 bis 0,2 mbar und insbesondere bevorzugt 0,06 bis 0,16 mbar. Als Prozessgase werden Luft, N₂, N₂O, Ar, He, O₂, bevorzugt Luft oder Argon besonders bevorzugt Argon eingesetzt. Die Dauer der Behandlung beträgt 10 Sekunden bis 1000 Sekunden, bevorzugt 30 Sekunden bis 500 Sekunden und insbesondere bevorzugt 30 Sekunden - 180 Sekunden.
   Vorbehandlung des erhaltenen Formteils enthaltend ein Substratmaterial aus Komponente S mit einem Gewichtsanteil aus von 1,1-Bis-(4-hydroxyphenyl)-3,3,5-trimethylcyclohexan abgeleiteten Bisphenol-Blöcken von 51 Gew.-% bis 95 Gew.-% bezogen auf die Gesamtmenge an eingesetzten Bisphenolen einer Diodenanordnung mit Mittelfrequenzanregung mit einem Luft- oder Argon-basierten Plasma bei einer Frequenz von 0 Hz - 10 Mhz bevorzugt von 0 Hz - 1 Mhz ganz besonders bevorzugt 0 Hz - 100 kHz und einer Leistung von 3,1 W/cm² bis 8,3 W/cm² bevorzugt 3,2 W/cm² bis 5 W/cm² insbesondere bevorzugt von 3,3 W/cm² bis 4,2 W/cm² sowie einem Prozessgasdruck von 0,04 bis 0,15 mbar bevorzugt von 0,05 bis 0,12 mbar. Als Prozessgase werden Luft, N₂, N₂O, Ar, He, O₂, bevorzugt Luft oder Argon besonders bevorzugt Argon eingesetzt. Die Dauer der Behandlung beträgt 10 Sekunden bis 1000 Sekunden, bevorzugt 30 Sekunden bis 500 Sekunden und insbesondere bevorzugt 30 Sekunden - 180 Sekunden.
c) Metallisierung des Formteils in einem Sputterprozess in einem DC-Magnetron in einem Argon-Plasma bei einem Druck von 5x10⁻³ mbar aus Aluminium, Silber, Chrom, Titan, Palladium, bevorzugt aus Silber oder Aluminium, insbesondere bevorzugt Aluminium bei einer Prozesszeit von 10 Sekunden bis 1000 Sekunden.

Die Dicke der Metallschicht beträgt bevorzugt 10 nm - 1000 nm, bevorzugt 50 nm - 800 nm insbesondere bevorzugt 60 nm - 500 nm und ganz besonders bevorzugt 60 nm - 300 nm.
d) Auftrag einer Schutzschicht (nachfolgend auch Top Coat genannt) mit der unter b) beschriebenen technischen Einrichtung. Dies geschieht bei einem Druck von 0,01 bis 0,30 mbar mit bevorzugt HMDSO (Hexamethyldisiloxan; CAS 107-46-0) als Beschichtungsmaterial bei einer Prozesszeit von 10 Sekunden - 1000 Sekunden bevorzugt 20 Sekunden bis 500 Sekunden. Die Schichtdicke des Top Coats beträgt 5 nm - 200 nm bevorzugt 20 nm - 100 nm.

Gegenstand der vorliegenden Anmeldung sind weiterhin Mehrschichtsysteme enthaltend eine Schicht i) enthaltend ein Substratmaterial aus Komponente S beziehungsweise einer Mischung von Komponente S mit oben beziehungsweise weiter unten genannten Polymeren der Formel (I), (II) oder (V), sowie mindestens eine Schicht ii) gebildet aus einem Metall, wobei das Metall bevorzugt aus Aluminium, Silber, Chrom, Titan, Palladium, bevorzugt aus Aluminium besteht, wobei auch Legierungen enthaltend diese Metalle umfasst sind, und der Auftrag des Metalls nach dem erfindungsgemäßen Verfahren erfolgte.

Dabei weist i) eine Schichtdicke von 0,1 mm bis 6,0 mm bevorzugt 0,2 mm bis 5,0 mm und insbesondere bevorzugt 0,5 mm bis 4,0 mm auf.

Die Schicht ii) weist bevorzugt eine Dicke von 10 nm- 1000 nm insbesondere bevorzugt 30 nm - 500 nm und ganz besonders bevorzugt 40 nm - 300 nm auf.

In einer speziellen Ausführungsform trägt die Schicht ii) eine Schutzschicht iii) bestehend aus plasmapolymerisierten Siloxanen der Dicke 5 nm - 200 nm, bevorzugt 15 nm - 150 nm ganz besonders bevorzugt 20 nm - 100 nm.

In einer weiteren speziellen Ausführungsform kann weiterhin eine Schicht iv) enthalten sein, die eine Kondensatbildung auf der Oberfläche verhindert.

Die aus dem erfindungsgemässen Verfahren erhaltenen Mehrschichtkörper weisen signifikant verbesserte thermische Eigenschaften (Vicat-Erweichungstemperatur) in Verbindung mit einer guten Metallisierbarkeit auf. Die Oberflächenqualität bei auch bei hoher Temperaturbelastung erhalten. Dabei bleiben die mechanischen, thermischen und rheologischen Eigenschaften gegenüber den Standard-Copolycarbonaten (wie z.B. Apec) unverändert.

Insbesondere finden diese Mehrschichtkörper Verwendung in der Herstellung von Reflektoren, Lampeneinfassungen oder Lampenabdeckungen.

Die Polymerzusammensetzung des Substratmaterials (Komponente S) kann niedermolekulare Additive enthalten. Allerdings ist es bevorzugt mit möglichst geringen Mengen an Additiven zu arbeiten. In einer besonderen Ausführungsform enthält die Polymerzuammensetzung keine Additive. Sind diese Additive optional enthalten, dann sind die bevorzugten Mengen im Bereich von 0,0 Gew.-% bis 5 Gew.-%, bezogen auf das Gewicht des Copolycarbonats, bevorzugt 0,01 Gew.-% bis 1,00 Gew.-%.

Als UV-Stabilisatoren eignen sich bevorzugt 2-(2'-Hydroxyphenyl)benzotriazole, 2-Hydroxybenzophenone, Ester von substituierten und unsubstituierten Benzoesäuren, Acrylate, sterisch gehinderte Amine, Oxamide, 2-(2-Hydroxyphenyl)-1,3,5-triazine, besonders bevorzugt sind substituierte Benztriazole wie beispielsweise Tinuvin 360, Tinuvin 350, Tinuvin 234, Tinuvin 329 oder UV CGX 006 (Ciba). In einer besonderen Ausführungsform wird kein Entformungsmittel eingesetzt.

Des weiteren können Farbmittel, wie organische Farbstoffe oder Pigmente oder anorganische Pigmente, IR-Absorber, einzeln, im Gemisch oder auch in Kombination mit Stabilisatoren, Glas(hohl)kugeln, anorganischen Füllstoffen oder organische oder anorganische Streupigmente zugesetzt werden. Dabei ist die erfindungsgemäße Zusammensetzung bevorzugt frei von Titandioxid.

Die Zusammensetzung kann weitere handelsübliche Polymeradditive wie Flammschutzmittel, Flammschutzsynergisten, Antidrippingmittel (beispielsweise Verbindungen der Substanzklassen der fluorierten Polyolefine, der Silikone sowie Aramidfasern), Nukleiermittel, Antistatika (beispielsweise Leitrusse, Carbonfasern, Carbon Nanotubes sowie organische Antistatika wie Polyalkylenether, Alkylsulfonate oder Polyamid-haltige Polymere) in solchen Mengen enthalten, die die mechanischen Eigenschaften der Zusammensetzung nicht insoweit schädigen, dass das Zieleigenschaftsprofil nicht mehr erfüllt wird.

Geeignete Additive sind beispielsweise beschrieben in "Additives for Plastics Handbook, John Murphy, Elsevier, Oxford 1999", im "Plastics Additives Handbook, Hans Zweifel, Hanser, München 2001" oder in WO 99/55772 , S. 15-25.

Neben den Additiven können auch noch Thermostabilisatoren und Entformungsmittel in der Zusammensetzung enthalten sein.

Als Thermostabilisator eignen sich bevorzugt Triphenylphosphin, Tris-(2,4-di-tert-butylphenyl)phosphit (Irgafos 168), Tetrakis(2,4-di-tert.-butylphenyl)[1,1biphenyl]-4,4'-diylbisphosphonit, Trisoctylphosphat, Octadecyl-3-(3,5-di-tert butyl-4-hydroxyphenyl)propionat (Irganox 1076), Bis(2,4-dicumylphenyl)pentaerythritoldiphosphit (Doverphos S-9228), Bis(2,6-di-tert.butyl-4-methylphenyl)pentaerythritoldiphosphit (ADK STAB PEP-36). Sie werden allein oder im Gemisch (z. B. Irganox B900 oder Doverphos S-92228 mit Irganox B900 beziehungsweise Irganox 1076) eingesetzt. Insbesondere bevorzugt ist Triphenylphosphin. In einer besonderen Ausführungsform wird kein Thermostabilisator eingesetzt. Sind diese Thermostabilisatoren optional enthalten, dann sind die bevorzugten Mengen im Bereich von 0,00 Gew.-% bis 0,20 Gew.-%, bezogen auf das Gewicht des Copolycarbonats, bevorzugt 0,01 Gew.-% bis 0,10 Gew.-%.

Als Entformungsmitttel eignen sich bevorzugt Pentaerythrittetrastearat, Glycerinmonostearat, Stearylstearat oder Propoandiolmono- beziehungsweise distearat. Sie werden allein oder im Gemisch eingesetzt. In einer besonderen Ausführungsform wird kein Entformungsmittel eingesetzt. Sind diese Entformungsmittel optional enthalten, dann sind die bevorzugten Mengen im Bereich von 0,00 Gew.-% bis 1,00 Gew.-% , bezogen auf das Gewicht des Copolycarbonats, bevorzugt 0,01 Gew.-% bis 0,50 Gew.-%, besonders bevorzugt 0,01 Gew.-% bis 0,40 Gew.-%.

Die erfindungsgemässen thermoplastischen Formmassen werden hergestellt, indem man die jeweiligen Bestandteile in bekannter Weise vermischt und bei Temperaturen von 200°C bis 380°C, bevorzugt bei 240 bis 350°C, in üblichen Aggregaten wie Innenknetern, Extrudern und Doppelwellenschnecken schmelzecompoundiert und schmelzextrudiert.

Die Polymerzusammensetzungen werden insbesondere zur Herstellung von Bauteilen verwendet, bei denen optische, thermische und mechanische Eigenschaften genutzt werden, wie beispielsweise Gehäuse, Gegenstände im E/E-Bereich, wie Stecker, Schalter, Platten, Lampenhalterungen, - abdeckungen, Automobilbereich wie Lampenfassungen und -abdeckungen, Verscheibungen und andere Anwendungen.

Die Extrudate und Formkörper beziehungsweise Formteile aus den erfindungsgemässen Polymeren sind ebenfalls Gegenstand der vorliegenden Anmeldung.

Die Copolycarbonate der Komponente S werden nach einem kontinuierlichen Phasengrenzflächenverfahren hergestellt. Die Herstellung der erfindungsgemäss zu verwendenden Copolycarbonate erfolgt prinzipiell in bekannter Weise aus Bisphenolen, Kohlensäurederivaten und gegebenenfalls Verzweigern.

Allgemein ist das Verfahren zur Polycarbonatsynthese bekannt und in zahlreichen Publikationen beschrieben. EP 517 044 A1, WO 2006/072 344 A1 sowie EP 1 609 818 A1 und dort zitierte Dokumente beschreiben beispielsweise das Phasengrenzflächen und das Schmelzeverfahren zur Herstellung von Polycarbonat.

Die verwendeten Bisphenole, wie auch alle anderen der Synthese zugesetzten Chemikalien und Hilfsstoffe können mit den aus ihrer eigenen Synthese, Handhabung und Lagerung stammenden Verunreinigungen kontaminiert sein. Es ist jedoch wünschenswert, mit möglichst reinen Rohstoffen zu arbeiten.

Die Durchführung der Copolycarbonatsynthese erfolgt kontinuierlich. Die Reaktion kann in daher in Umpumpreaktoren, Rohrreaktoren, oder Rührkesselkaskaden oder deren Kombinationen erfolgen, wobei durch Verwendung der bereits erwähnten Mischorgane sicherzustellen ist, dass wässrige und organische Phase sich möglichst erst dann entmischen, wenn das Synthesegemisch ausreagiert hat, d. h. kein verseifbares Chlor von Phosgen oder Chlorkohlensäureestern mehr enthält.

Die Menge an einzusetzenden Kettenabrecher beträgt 0,5 Mol-% bis 10 Mol-%, bevorzugt 1 Mol-% bis 8 Mol-%, besonders bevorzugt 2 Mol-% bis 6 Mol-% bezogen auf Mole an jeweils eingesetzten Bisphenolen. Die Zugabe der Kettenabbrecher kann vor, während oder nach der Phosgenierung erfolgen, bevorzugt als Lösung in einem Lösungsmittelgemisch aus Methylenchlorid und Chlorbenzol (8-15 Gew.%-ig).

### Beispiele

Im Folgenden wird die Erfindung anhand von Ausführungsbeispielen näher beschrieben, wobei die hier beschriebenen Bestimmungsmethoden für alle korrespondierenden Größen in der vorliegenden Erfindung zur Anwendung kommen, sofern nichts Gegenteiliges beschrieben worden ist.

Die Bestimmung des Schmelzvolumenrate (MVR) erfolgt nach ISO 1133 unter den unten angegebenen Bedingungen.

### Materialien:

### Copolycarbonat Komponente S:

Typ 1 : Copolycarbonat enthaltend 42 Gew.-% 1,1-Bis-(4-hydroxyphenyl)-3,3,5-trimethylcyclohexan und 58 Gew.-% Bisphenol A mit Phenol als Kettenabbrecher und einem MVR von 18 cm³/(10 min) (330°C; 2,16 kg) gemäß ISO 1133 wird mit 0,004 Gew.-%, bezogen auf das Gewicht des Copolycarbonats, Ruß (Lampblack 101, Evonik Carbon Black GmbH, 60287 Frankfurt a. M., Deutschland, Color Index: 77262) und 0,1 Gew.-%, bezogen auf das Gewicht des Copolycarbonats, Titandioxid (Kronos 2230; Kronos International Inc., 51373 Leverkusen, Deutschland) unter unten beschriebenen Bedingungen compoundiert. Das resultierende Material hat eine Vicat-Erweichungstemperatur von 183°C (ISO 306; 50 N; 120 K/h).

Typ 2: Copolycarbonat enthaltend 67 Gew.-% 1,1-Bis-(4-hydroxyphenyl)-3,3,5-trimethylcyclohexan und 15 Gew.-% Bisphenol A mit Phenol als Kettenabbrecher und einem MVR von 5 cm³/(10 min) (330°C; 2,16 kg) gemäß ISO 1133 wird mit 0,004 Gew.-%, bezogen auf das Gewicht des Copolycarbonats, Ruß (Lampblack 101, Evonik Carbon Black GmbH, 60287 Frankfurt a. M., Deutschland, Color Index: 77262) und 0,1 Gew.-%, bezogen auf das Gewicht des Copolycarbonats, Titandioxid (Kronos 2230; Kronos International Inc., 51373 Leverklusen, Deutschland) unter unten beschriebenen Bedingungen compoundiert. Das resultierende Material hat eine Vicat-Erweichungstemperatur von 203°C (ISO 306; 50 N; 120 K/h).

Typ 3: Ein Copolycarbonat enthaltend 13 Gew.-% 1,1-Bis-(4-hydroxyphenyl)-3,3,5-trimethylcyclohexan und 87 Gew.-% Bisphenol A mit Phenol als Kettenabbrecher und einem MVR von 46 cm³/(10 min) (330°C; 2,16 kg) gemäß ISO 1133 weist eine Vicat-Erweichungstemperatur von 158 °C auf. Da Dieses Polycarbonat folglich eine Vicattemperatur von unterhalb 160°C aufweist und sich entsprechende Formkörper bei Lagertemperaturen oberhalb 160°C verbiegen sind diese Copolycarbonate ungeeignet im Sinne des erfindungsgemäßen Verfahrens.

### Compoundierung

Die Compoundierung der Materialien erfolgte auf einem Zweiwellenextruder der Firma KraussMaffei Berstorff, TYP ZE25, bei einer Gehäusetemperatur von 320°C beziehungsweise einer Massetemperatur von ca. 340°C und einer Drehzahl von 110 Upm mit den in den Beispielen angegebenen Mengen an Komponenten.

### Herstellung der Prüfkörper

Zur Untersuchung der Metallisierungseigenschaften wurden Spritzguss-Rechteckplatten mit den Maßen 150 x 105 x 3,2 mm mit Seitenanguss in optischer Qualität angefertigt. Die Massetemperatur betrug 300 - 330°C und die Werkzeugtemperatur 100°C. Das jeweilige Granulat wurde vor Verarbeitung für 5 Stunden im Vakuumtrockenschrank bei 120°C getrocknet.

### Messung der Wärmeformbeständigkeit über die Vicat-Erweichungstemperatur

Die Vicat-Erweichungstemperatur nach DIN EN ISO 306 wird mit einer Nadel (mit kreisrunder Fläche von 1 mm²) gemessen. Diese ist mit einer Prüfkraft von 50 N (Prüfkraft B) belastet. Der oben genannte Probekörper wird einer definierten Heizrate von 120 K/h ausgesetzt. Die Vicattemperatur ist erreicht, wenn der Eindringkörper eine Eindringtiefe von 1 mm erreicht. Sie wird nach DIN ISO 306 gemessen.

### Metallisierungsprozess

Alle Platten wurden vor der Beschichtung für 21 Tage bei 50 % Luftfeuchtigkeit und 23°C gelagert.

Die Beschichtungsanlage bestand aus einer Vakuumkammer bei der die Proben auf einem rotierenden Probenhalter positioniert wurden. Der Probenhalter rotierte mit ca. 20 U/min. Die Prüfkörper wurden, bevor sie in die Vakuumkammer eingebracht wurden, mit ionisierter Luft abgeblasen, um sie von Staub zu befreien. Danach wurde die Vakuumkammer mit den Prüfkörper auf einen Druck p ≤ 1· 10⁻⁵ mbar evakuiert. Anschließend wurde Argon Gas bis zu einem bestimmten Druck, welcher in den Ausführungsbeispielen beschrieben ist (Prozessdruck 1) eingelassen und bei einer bestimmten Leistung, welche in den Ausführungsbeispielen beschrieben ist (Prozessleistung 1) für 2 min ein Plasma gezündet und die Proben diesem Plasma ausgesetzt (Plasmavorbehandlung). Als Plasmaquelle wurde eine Diodenanordung bestehend aus 2 parallelen Metallelektroden verwendet, die mit einer Wechselfrequenz von 40 kHz und einer Spannung größer 1000V betrieben wurde. Danach wurden die Proben metallisiert. Dafür wurde Ar-Gas mit einem Druck von 5· 10⁻³ mbar eingelassen. Mittels DC-Magnetron wurde eine Aluminium-Schicht von ca. 100 nm Dicke mit einer Leistungsdichte von 6,4 W/cm² auf die Proben aufgebracht. Die Sputterzeit betrug 2,5 min. Danach wurde mittels Plasmapolymerisation eine Korrosionsschutzschicht aus HMDSO aufgebracht. Dazu wurde HMDSO verdampft und der Dampf in die Vakuumkammer eingelassen bis sich ein Druck von ca. 0,07 mbar ergab. Danach wurde ein Plasma mit der oben beschriebenen Diodenanordnung bei 1000W gezündet während 1 Minute die Korrosionschutzschicht aufgebracht.

### Test der Oberflächenqualität nach Wärmelagerung

Der Test wird direkt nach der Metallisierung durchgeführt. Damit ist gemeint, dass die Platten nach Metallisierung innerhalb einer Stunde diesem Test unterworfen werden.

Die metallisierten Platten werden dabei in einer Klimakammer für 3 Stunden bei 45°C und 100 % relativer Feuchte gelagert. Direkt nach der Klimalagerung werden die Platten für eine Stunde bei 165 beziehungsweise 185°C in einem Ofen gelagert.

Danach wird die Metalloberfläche abgemustert.

### Visuelle Abmusterung

Die Oberfläche wird auf blasenförmige Aufwerfungen, Eintrübung der Metallschicht sowie auf Irisierung untersucht. Platten, die weder Irisierung noch Trübung, noch Blasen aufweisen, werden als "sehr gut" gekennzeichnet.

### Beispiel 1 (Vergleichsbeispiel)

Es werden Spritzguss-Rechteckplatten von Komponente S Typ 1 wie oben beschrieben angefertigt.

Danach werden die Probekörper wie oben beschrieben metallisiert. Der Prozessdruck 1 beträgt dabei 0,01 mbar und die Prozessleistung 1 beträgt dabei 0,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 2 (Vergleichsbeispiel)

Es werden Spritzguss-Rechteckplatten von Komponente S Typ 1 wie oben beschrieben angefertigt.

Danach werden die Probekörper wie oben beschrieben metallisiert. Der Prozessdruck 1 beträgt dabei 0,04 mbar und die Prozessleistung 1 beträgt dabei 0,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 3 (Vergleichsbeispiel)

Es werden Spritzguss-Rechteckplatten von Komponente S Typ 1 wie oben beschrieben angefertigt. Danach werden die Probekörper wie oben beschrieben metallisiert. Der Prozessdruck 1 beträgt dabei 0,12 mbar und die Prozessleistung 1 beträgt dabei 0,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 4 (Vergleichsbeispiel)

Es werden Spritzguss-Rechteckplatten von Komponente S Typ 1 wie oben beschrieben angefertigt. Danach werden die Probekörper wie oben beschrieben metallisiert. Der Prozessdruck 1 beträgt dabei 0,12 mbar und die Prozessleistung 1 beträgt dabei 0,33 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 5 (Vergleichsbeispiel)

Es werden Spritzguss-Rechteckplatten von Komponente S Typ 1 wie oben beschrieben angefertigt. Danach werden die Probekörper wie oben beschrieben metallisiert. Der Prozessdruck 1 beträgt dabei 0,01 mbar und die Prozessleistung 1 beträgt dabei 2,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 6 (erfindungsgemäß)

Es werden Spritzguss-Rechteckplatten von Komponente S Typ 1 wie oben beschrieben angefertigt. Danach werden die Probekörper wie oben beschrieben metallisiert. Der Prozessdruck 1 beträgt dabei 0,12 mbar und die Prozessleistung 1 beträgt dabei 2,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 7 (erfindungsgemäß)

Es werden Spritzguss-Rechteckplatten von Komponente S Typ 1 wie oben beschrieben angefertigt. Danach werden die Probekörper wie oben beschrieben metallisiert. Der Prozessdruck 1 beträgt dabei 0,16 mbar und die Prozessleistung 1 beträgt dabei 4,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 8 (Vergleichsbeispiel)

Es werden Spritzguss-Rechteckplatten von Komponente S Typ 2 wie oben beschrieben angefertigt. Danach werden die Probekörper wie oben beschrieben metallisiert. Der Prozessdruck 1 beträgt dabei 0,12 mbar und die Prozessleistung 1 beträgt dabei 2,83 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 9 (Vergleichsbeispiel)

Es werden Spritzguss-Rechteckplatten von Komponente S Typ 2 wie oben beschrieben angefertigt. Danach werden die Probekörper wie oben beschrieben metallisiert. Der Prozessdruck 1 beträgt dabei 0,16 mbar und die Prozessleistung 1 beträgt dabei 3,5 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 10 (erfindungsgemäß)

Es werden Spritzguss-Rechteckplatten von Komponente S Typ 2 wie oben beschrieben angefertigt. Danach werden die Probekörper wie oben beschrieben metallisiert. Der Prozessdruck 1 beträgt dabei 0,12 mbar und die Prozessleistung 1 beträgt dabei 3,5 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

### Beispiel 11 (erfindungsgemäß)

Es werden Spritzguss-Rechteckplatten von Komponente S Typ 2 wie oben beschrieben angefertigt. Danach werden die Probekörper wie oben beschrieben metallisiert. Der Prozessdruck 1 beträgt dabei 0,12 mbar und die Prozessleistung 1 beträgt dabei 4,17 W/cm². Alle anderen Parameter zur Herstellung der Metallschicht beziehungsweise Erzeugung des Topcoats werden wie oben beschrieben eingestellt.

Das Ergebnis der Prüfung (Wärmelagerung) ist in Tabelle 1 dargestellt.

**Tabelle 1**

| Bsp. | Substrat | Vorbehandlung Sputterprozess | Temperatur Wärmelagerg | Visuelle Abmusterung |
|---|---|---|---|---|
| 1 | Komponente S Typ 1 | P-leistung 1: 0,17 W/cm² | 165°C | Blasen |
| Vergleich | | P-druck 1: 0,01 mbar | | Irisiert |
| 2 | Komponente S Typ 1 | P-leistung 1: 0,17 W/cm² | 165°C | Blasen |
| Vergleich | | P-druck 1: 0,04 mbar | | Irisiert |
| 3 | Komponente S Typ 1 | P-leistung 1: 0,17 W/cm² | 165°C | Blasen |
| Vergleich | | P-druck 1: 0,12 mbar | | Irisiert |
| 4 | Komponente S Typ 1 | P-leistung 1: 0,33 W/cm² | 165°C | Blasen |
| Vergleich | | P-druck 1: 0,12 mbar | | Irisiert |
| 5 | Komponente S Typ 1 | P-leistung 1: 2,17 W/cm² | 165°C | Blasen |
| Vergleich | | P-druck 1: 0,01 mbar | | |
| 6 | Komponente S Typ 1 | P-leistung 1: 2,17 W/cm² | 165°C | Ohne Defekt |
| Erfindgsgem. | | P-druck 1: 0,12 mbar | | |
| 7 | Komponente S Typ 1 | P-leistung 1: 4,17 W/cm² | 165°C | Ohne Defekt |
| Erfindgsgem. | | P-druck 1: 0,16 mbar | | |
| 8 | Komponente S Typ 2 | P-leistung 1: 2,83 W/cm² | 185°C | Blasen |
| Vergleich | | P-druck 1: 0,12 mbar | | |
| 9 | Komponente S Typ 2 | P-leistung 1: 3,5 W/cm² | 185°C | Blasen |
| Vergleich | | P-druck 1: 0,16 mbar | | |
| 10 | Komponente S Typ 2 | P-leistung 1: 3,5 W/cm² | 185°C | Ohne Defekt |
| Erfindgsgem. | | P-druck 1: 0,12 mbar | | |
| 11 | Komponente S Typ 2 | P-leistung 1: 4,17 W/cm² | 185°C | Ohne Defekt |
| Erfmdgsgem. | | P-druck 1: 0,12 mbar | | |

Bei Verwendung von Komponente S Typ 1 (42 Gew.-% 1,1-Bis-(4-hydroxyphenyl)-3,3,5-trimethylcyclohexan und 58 Gew.-% Bisphenol A) als Substratmaterial für die Basisschicht zeigt sich, dass bei speziellen Drücken und speziellen Sputterenergien sehr gute Oberflächenqualitäten möglich sind (Beispiele 6 und 7). Insbesondere sind höhere Sputterenergien in Kombination mit höheren Drücken von Vorteil. Demgegenüber treten bei Komponente S Typ 2 mit einem höheren Gewichtsanteil an 1,1-Bis-(4-hydroxyphenyl)-3,3,5-trimethylcyclohexan bei höheren Drücken überraschenderweise negative Effekte an der Oberfläche auf. Auch Prozessleistungen (Prozessleistung 1), die bei Typ 1 zu sehr guten Ergebnissen geführt haben zeigen bei Typ 2 negative Effekte. Bei der Metallisierung von Typ 2 muss die Leistung (Prozessleistung 1) noch in einem deutlichen Maße erhöht werden, um gute Oberflächenqualitäten zu erzeugen.

## Patentansprüche

1. Verfahren zur Herstellung von Mehrschichtkörpern, **dadurch gekennzeichnet, dass** ein Substratmaterial enthaltend ein Copolycarbonat, welches mindestens ein Bisphenolbaustein der Formel (2) enthält, 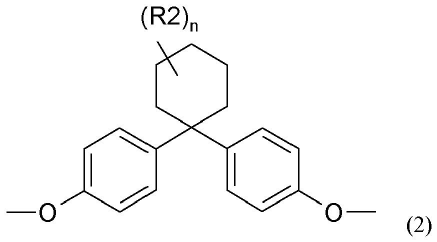 in der
R2 für C1-C4-Alkyl,
n für 0, 1, 2 oder 3,
sowie als Endgruppe (Kettenabbrecher) eine Struktureinheit der Formel (1) enthält 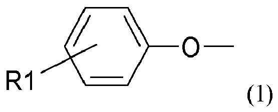 in der
R1 für Wasserstoff oder C1-C18-Alkyl stehen,
und einer Vicat-Erweichungstemperatur nach DIN ISO 306 von größer als 160°C hat,
zu einem Formkörper verarbeitet wird,
wobei dieser Formkörper mit einem Luft- oder Argon-basierten Plasma vorbehandelt wird und anschließend mittels eines Sputterprozesses in einem DC-Magnetron metallisiert wird.

2. Verfahren zur Herstellung von Mehrschichtkörpern nach Anspruch 1, **dadurch gekennzeichnet, dass** R2 für Methyl-, Ethyl-, Propyl-, Isopropyl- und Butyl- oder Isobutylrest steht, n für 2 oder 3 steht und, ist die Struktureinheit der Formel (1) ein Phenolat-Rest oder ein tert.-Butylphenolat-Rest oder ein n-Butylphenolat-Rest, insbesondere ein Phenolat-Rest oder ein p-tert. Butylphenolat-Rest.

3. Verfahren nach Anspruch 1 oder 2, worin das Substratmaterial zu 15 Gew.-% - 50 Gew.-%, bezogen auf die Gesamtmenge der Bisphenol-blöcken, aus von 1,1-Bis-(4-hydroxyphenyl)-3,3,5-trimethylcyclohexan abgeleiteten Bisphenolbaustein besteht.

4. Verfahren nach Anspruch 1 oder 2, worin das Substratmaterial 51 Gew.-% bis 95 Gew.-% , bezogen auf die Gesamtmenge der Bisphenol-blöcken, aus von 1,1-Bis-(4-hydroxyphenyl)-3,3,5-trimethylcyclohexan abgeleiteten Bisphenolbaustein besteht.

5. Verfahren nach einem der Ansprüche 1 bis 4, **dadurch gekennzeichnet, dass** die Plasmavorbehandlung mit einer Mittelfrequenzanregung mit einem Luft- oder Argon-basierten Plasma bei einer Frequenz von 0 Hz - 10 Mhz bei einer Leistung von 0,4 W/cm² bis 8,4 W/cm² sowie einem Prozessgasdruck von 0,04 bis 0,4 mbar erfolgt.

6. Verfahren nach einem der Ansprüche 1 bis 4, **dadurch gekennzeichnet, dass** die Plasmavorbehandlung mit einer Mittelfrequenzanregung mit einem Luft- oder Argon-basierten Plasma bei einer Frequenz von 0 Hz - 10 Mhz bei einer Leistung von 3,1 W/cm² bis 8,3 W/cm² sowie einem Prozessgasdruck von 0,04 bis 0,15 mbar erfolgt.

7. Mehrschichtkörper erhältlich durch ein Verfahren nach einem der Ansprüche 1 bis 6, **dadurch gekennzeichnet, dass** das Copolycarbonat 15 Gew.-% bis 95 Gew.-% , bezogen auf die Gesamtmenge der Bisphenol-blöcken, aus von 1,1-Bis-(4-hydroxyphenyl)-3,3,5-trimethylcyclohexan abgeleiteten Bisphenolbaustein und zu 85 - 5 Gew.-% , bezogen auf die Gesamtmenge der Bisphenol-blöcken, aus von Bisphenol A abgeleiteten Blöcken besteht, wobei sich die Gesamtsumme auf 100% aufaddiert.

8. Mehrschichtkörper nach Anspruch 7 **dadurch gekennzeichnet, dass** das Copolycatbonat 0,01 Gew.-% bis 0,10 Gew.-% , bezogen auf das Gewicht des Copolycarbonats, Triphenylphosphin sowie 0,01 bis 0,4 Gew.-% , bezogen auf das Gewicht des Copolycarbonats, Pentaerythrittetrastearat, enthält.

9. Mehrschichtkörper nach Anspruch 7 oder 8 **dadurch gekennzeichnet, dass** das Copolycatbonat Titandioxid in einer Menge von 0,10 Gew.-% bis 2,50 Gew.-% bezogen auf das Gewicht des Copolycarbonats enthält..

10. Verwendung von Mehrschichtkörper nach Ansprüchen 7 bis 9 zur Herstellung von metallisierten Formteile.

11. Mehrschichtkörper nach einem der Ansprüche 7 bis 9 wobei der Mehrschichtkörper auf der Metallschicht zusätzlich eine Schutzschicht bestehend aus plasmapolymerisierten Siloxanen enthält.

12. Mehrschichtkörper nach Anspruch 11 wobei die Substratschicht eine Dicke von 0,1 mm bis 6,0 mm, die Metallschicht eine Dicke von 10 nm - 1000 nm sowie die eine Schutzschicht bestehend aus plasmapolymerisierten Siloxanen mit einer Dicke von 5 nm - 200 nm aufweist.

13. Mehrschichtkörper nach Anspruch 11 oder 12 wobei die Metallschicht eine Aluminium oder Silberschicht ist.

14. Mehrschichtkörper nach einem der Ansprüche 11 bis 13 zur Herstellung eines Reflektors, einer Lampeneinfassung oder Lampenabdeckung.
